# EUROPÄISCHE PATENTANMELDUNG

(11) **EP 3 886 184 A1**
(43) Veröffentlichungstag der Anmeldung: **29.09.2021**
(21) Anmeldenummer: 21163525.5
(22) Anmeldetag: 18.03.2021
(51) Int. Cl.: H01L 31/0463, H01L 31/0465, H01L 31/032, H01L 31/078, H01L 51/42, H01L 27/30

(54) **STAPELSOLARZELLENMODUL UND VERFAHREN ZUR HERSTELLUNG DES STAPELSOLARZELLENMODULS**

(30) Priorität: 26.03.2020 DE 102020108334
(71) Anmelder: Helmholtz-Zentrum Berlin für Materialien und Energie GmbH, 14109 Berlin (DE)
(72) Erfinder: Farias Basulto, Guillermo Antonio, 10967 Berlin (DE); Schlatmann, Rutger, 14195 Berlin (DE)

(57) **Zusammenfassung**

Die Erfindung betrifft ein Stapelsolarzellenmodul (5), welches mindestens zwei Stapelsolarzellen (1, 1', 1a-1d), aufweist. Jeder der Stapelsolarzellen (1, 1', 1a-1d) weist dabei eine Rückseitenkontaktschicht (10), eine Gruppe zentraler Schichten (20, 30, 40) und eine obere Kontaktschicht (50) auf. Die Gruppe zentraler Schichten (20, 30, 40) umfasst dabei mindestens zwei Teilsolarzellen (20, 40) mit mindestens jeweils einer Absorberschicht zwischen denen jeweils mindestens eine leitfähige Zwischenschicht (30) angeordnet ist. Zudem weist jede Rückseitenkontaktschicht (10) einer Stapelsolarzelle ein isolierendes Segment (60) auf, das die Rückseitenkontaktschicht (10) elektrisch trennt, so dass Abschnitte (10_1, 10_1', 10_2) gebildet sind und in der leitfähigen Zwischenschicht (30) einen Schichtisolator (70) und einen schichtübergreifender Leiter (90), der die Gruppe zentraler Schichten (20, 30, 40) umfasst und die obere Kontaktschicht (50) elektrisch mit einem Abschnitt (10_1, 10_1', 10_2) der Rückseitenkontaktschicht (10) verbindet. Dabei sind die einzelnen Stapelsolarzellen (1, 1', 1a-1d) ,in dem Stapelsolarzellenmodul (5) durch Zellseparatoren (80) voneinander getrennt, die sich von der oberen Kontaktschicht (50), und diese umfassend, bis zu der, der Rückseitenkontaktschicht (10) am nächsten liegenden Schicht einer Teilsolarzelle (20), und diese umfassend, erstrecken und wobei für eine, in einer Reihe endständige Stapelsolarzelle (1, 1', 1a-1d) im Stapelsolarzellenmodul (5) der Zellseparator (80) durch das Enden des Moduls (5) gegeben ist. In jeder Stapelsolarzelle (1, 1', 1a-1d) ist dabei der schichtübergreifende Leiter (90) zwischen dem jeweiligen Schichtisolator (70) und dem Zellseparator (80) angeordnet und jeweils zwei benachbarte Stapelsolarzellen (1, 1', 1a-1d) sind über einen, sich von einer Stapelsolarzelle (1, 1', 1a-1d) in die nächste erstreckenden Abschnitt der Rückseitenkontaktschicht (10_1, 10_1', 10_2) elektrisch verbunden.

## Beschreibung

Die Erfindung bezieht sich auf ein Stapelsolarzellenmodul und ein Verfahren für die Herstellung eines erfindungsgemäßen Stapelsolarzellenmoduls.

Ein Solarzellenmodul, auch Solarmodul, umfasst mindestens zwei Solarzellen, die auch sogenannte Stapelsolarzellen sein können.

Der Begriff in Reihe ist im Folgenden synonym dem, aus dem englischen entsprechend "series circuit", entlehnten Begriff Serienschaltung oder serielle Verschaltung benutzt und bezeichnet eine Verschaltung, in der Bauelemente hintereinandergeschaltet sind, so dass sie einen einzigen Strompfad bilden.

Eine Solarzelle ist eine Vorrichtung, die konfiguriert ist, Lichtenergie in elektrische Energie umzuwandeln. Die Solarzelle umfasst dabei im Allgemeinen mindestens eine lichtabsorbierende Schicht, aus einem Material, welches lichtabsorbierend ist. Dieses Material absorbiert einfallende Photonen deren Energie die Ladungsträger im Material in einen angeregten Zustand konvertiert. Ein solches Material kann ein Halbleiter sein. Um die entstehenden Ladungsträger in einen elektrischen Strom zu überführen bedarf es im Allgemeinen eines elektrischen Feldes, das z.B. durch einen p-n-Übergang erzeugt werden kann. Der p-n-Übergang ist meistens durch mindestens eine entsprechende zusätzliche Schicht oder durch Abstufung in einem Material realisiert. In organischen Solarzellen ist durch die Erzeugung von sogenannten Exzitonen in dem organischen Absorbermaterial auch eine Realisierung mit einer Schicht, ohne räumlich getrennten p-n-Übergang, möglich. Zusätzlich sind in einer Solarzelle jeweils mindestens funktional elektrische -Kontakte (Elektroden), zumeist als Schichten ausgeführt, erforderlich. Weitere funktionale Schichten z.B. zur Verhinderung von Rekombinationen, Pufferschichten und solche zur Verbesserung der Reflektionseigenschaften können zugefügt sein.

Eine Solarzelle wandelt somit Lichtenergie in freie Ladungsträger, d. h. einen elektrischen Strom, um.

Eine kritische Eigenschaft der Solarzelle ist ihre Solarzelleneffizienz, insbesondere die Energieumwandlungseffizienz. Die Solarzelleneffizienz ist definiert als der Bruchteil des einfallenden Sonnenlichts, der in elektrische Energie umgewandelt wird und wobei die Energie zur Verrichtung von Arbeit genutzt werden kann. Die Energieumwandlungseffizienz ist das Verhältnis der zugeführten Energie und der erzeugten elektrischen Energie. Die Energieumwandlungseffizienz der Solarzelle hängt stark von dem lichtabsorbierenden Material ab, das in der Solarzelle oder in der Zusammensetzung der Solarzelle verwendet wird.

In den letzten Jahren wurden verschiedene Ansätze beschrieben, die Energieumwandlungseffizienz einer Solarzelle zu erhöhen. In "Solar cell efficiency tables" (seit 1993 zweimal jährlich in "Progress in Photovoltaics" veröffentlicht; letzte Veröffentlichung: "Solar cell efficiency tables (version 55)", Green, M.A. et al. (2019); Prog. Photovolt. 28, 3-15.") lässt sich die Entwicklung der Solarzellentechnologien und die Verbesserung der Energieumwandlungseffizienz verfolgen.

Ein Ansatz für die Erhöhung der Energieumwandlungseffizienz sind sogenannte "Multijunction"-Solarzellen, die auch als Mehrfach- oder Stapelsolarzellen (engl. multi-junction solar cell) bezeichnet werden und die aus mindestens zwei Teilsolarzellen bestehen. Die Stapelsolarzelle umfasst dementsprechend mindestens zwei übereinander angeordnete Teilsolarzellen, welche jeweils lichtabsorbierende Schichten, die auch als Absorberschichten bezeichnet werden, umfasst und die gegebenenfalls weiterhin nötigen Schichten zur Schaffung von p-n-Übergängen und Elektroden. Die Materialien dieser mindestens zwei Absorberschichten in einer Stapelsolarzelle sind dabei zumeist unterschiedlich zueinander. In vorteilhafter Weise ist jedes Material einer Absorberschicht ausgewählt in Hinblick darauf, Licht in einem bestimmten Wellenlängenbereich zu absorbieren, der sich mit dem Absorptionsbereich des Materials der anderen Absorberschichten ergänzt, so dass insgesamt, gegenüber der jeweiligen einzelnen Solarzelle, ein größerer Teil des einfallenden Lichtspektrums genutzt wird. In den Stapelsolarzellen können einzelne Schichten, z.B. leitfähige Zwischenschichten, die zwischen einzelnen Teilsolarzellen angeordnet sind, funktional zu jeweils zwei Teilsolarzellen zugerechnet werden und im Falle unterer und oberer Kontaktschichten funktional auch der gesamten Stapelsolarzelle.

Bei den aus dem Stand der Technik bekannten Stapelsolarzellenmodulen, und hier insbesondere den häufigen Tandemsolarzellenmodulen, tritt bei der Verbindung mehrerer Stapelsolarzellen das Problem auf, dass die Solarzellen in einem Solarzellmodul durch die Stapelung und das sich dadurch ergebende elektrische Layout nicht über eine monolithische elektrische Verbindung in Serie verschaltet werden können, wie dies z.B. in dem Übersichtartikel von Z. Li et al. (Scalable fabrication of perovskite solar cells, Nature Reviews | Materials, Vol. 3, 2018, 18017_1-20) für einfache Solarzellen berichtet ist, sondern über eine separat auf- bzw. einzubringende elektrische Verbindung. Die Verschaltung in Serie ist zu bevorzugen, da andernfalls hohe elektrische Ströme auftreten, da sich die elektrischen Ströme der verschalteten einzelnen Solarzellen addieren, während die gesamte Spannung eines parallel verschalteten Solarmoduls konstant bleibt. Diese verhältnismäßig hohen elektrischen Ströme in den Solarmodulen führen zu dissipativen Wärmeverlusten, die zu vermeiden sind.

Im Sinne der Erfindung bedeutet monolithische elektrische Verbindung, dass die elektrische Verbindung einstückig, d.h. aus einem Block bzw. Wafer oder Stück prozessiert ist.

Die Aufgabe der Erfindung ist es ein monolithisch elektrisch in Reihe verschaltetes Stapelsolarzellenmodul anzugeben, das auf einfache sowie kostengünstige Weise herstellbar ist und das dazugehörige Verfahren.

Die Aufgabe wird gelöst durch das Stapelsolarzellenmodul nach Anspruch 1 und, für das Verfahren zur Herstellung des Stapelsolarzellenmoduls nach Anspruch 6. Vorteilhafte Ausführungsformen sind in den abhängigen Unteransprüchen angegeben.

Eine, in einem erfindungsgemäßen Stapelsolarzellenmodul umfasste Stapelsolarzelle umfasst mehrere Schichten, wobei jede Schicht eine laterale Erstreckungsrichtung (d.h. Erstreckung in der Schichtebene) aufweist. Folgende Schichten sind mindestens gegeben:
- eine Rückseitenkontaktschicht,
- eine Gruppe zentraler Schichten, und
- eine obere Kontaktschicht.

Die Gruppe zentraler Schichten umfasst dabei mindestens zwei Teilsolarzellen mit mindestens jeweils einer Absorberschicht und gegebenenfalls benötigten funktionalen weiteren Schichten, wobei jeweils zwischen zwei Teilsolarzellen mindestens eine leitfähige Zwischenschicht angeordnet ist.

Die obere Kontaktschicht bestimmt die dem Lichteinfall zugewandte Seite der Stapelsolarzelle, die auch die, als die obere Seite der Stapelsolarzelle -und auch eines Stapelsolarzellenmodulsanzusprechende Seite bestimmt.

Erfindungsgemäß ist in einer Stapelsolarzelle des Stapelsolarzellenmoduls jeweils die Rückseitenkontaktschicht durch ein isolierendes Segment in zwei, in einer Stapelsolarzelle voneinander unterscheidbare Abschnitte unterteilt, wobei die elektrische Leitfähigkeit des isolierenden Segments geringer ist als die Leitfähigkeit der Rückseitenkontaktschicht, so dass das isolierende Segment die Abschnitte der Rückseitenkontaktschicht elektrisch voneinander isoliert.

Erfindungsgemäß ist in der Gruppe zentraler Schichten jeweils einer Stapelsolarzelle des Stapelsolarzellenmoduls ein schichtübergreifender Leiter angeordnet, welcher sich durch die einzelnen Schichten der Gruppe zentraler Schichten erstreckt bzw. diese umfasst und die obere Kontaktschicht und einen der zwei Abschnitte -pro Stapelsolarzelle- der Rückseitenkontaktschicht elektrisch miteinander verbindet, so dass ein Strompfad von der oberen Kontaktschicht zu diesem Abschnitt der Rückseitenkontaktschicht gebildet ist. Die Leitfähigkeit des schichtübergreifenden Leiters ist dabei mindestens so groß wie die der einzelnen leitfähigen Zwischenschichten und größer als die der übrigen Schichten, durch die er sich erstreckt.

Zusätzlich ist jede leitfähige Zwischenschicht einer Stapelsolarzelle des Stapelsolarzellenmoduls erfindungsgemäß durch jeweils einen Schichtisolator, in zwei Unterabschnitte geteilt, die folglich elektrisch voneinander isoliert sind. Die elektrische Leitfähigkeit des Schichtisolators ist dabei geringer als die der leitfähigen Zwischenschicht, so dass die leitfähige Zwischenschicht in zwei voneinander elektrisch isolierte Unterabschnitte getrennt ist.

Weiterhin ergibt sich erfindungsgemäß, dass jeweils zwei benachbarte Stapelsolarzellen über einen, sich von einer Stapelsolarzelle in die nächste erstreckenden Abschnitt der Rückseitenkontaktschicht elektrisch miteinander verbunden sind, so dass die Stapelsolarzellen im Stapelsolarzellenmodul über eine monolithische elektrische Verbindung in Reihe geschaltet sind. Die elektrische Verbindung ist dabei einstückig bzw. monolithisch ausgebildet.

Die einzelnen Stapelsolarzellen des Stapelsolarzellenmoduls sind durch Zellseparatoren, die sich jeweils durch die obere Kontaktschichten bis durch die unterste, d.h. die am nächsten zu der Rückseitenkontaktschicht angeordnete Schicht einer Teilsolarzelle erstrecken und vor der Rückseitenkontaktschicht enden, voneinander getrennt. Die Zellseparatoren sind dabei regelmäßig angeordnet, so dass jeweils ein isolierendes Segment der Rückseitenkontaktschicht und ein schichtübergreifender Leiter sowie jeweils pro leitfähiger Zwischenschicht der Stapelsolarzellen ein Schichtisolator vollständig zwischen zwei Zellseparatoren liegen, wobei folglich jeweils der Bereich zwischen zwei Zellseparatoren eine Stapelsolarzelle bildet. Im Grenzfall, das eine Stapelsolarzelle am Rand, d.h. am Ende einer Reihe von Stapelsolarzellen in einem Stapelsolarzellenmoduls angeordnet ist, entfällt auf der jeweils endständigen Seite der Zellseparator bzw. ist durch das Ende des Moduls gebildet. Jeder Stapelsolarzelle ist dabei ein Zellseparator zuzuordnen und einer endständigen Stapelsolarzelle in einer Reihe von Stapelsolarzellen anstelle eines Zellseparators das Ende des Moduls als Zellseparator.

Die isolierenden Segmente, die Schichtisolatoren, die schichtübergreifenden Leiter und die Zellseparatoren sind regelmäßig in einem ersten Abstand voneinander beabstandet.

Innerhalb der so gebildeten Stapelsolarzellen im Stapelsolarzellenmodul ist jeweils pro Stapelsolarzelle die Anordnung des isolierenden Segments in der Rückseitenkontaktschicht, der Schichtisolatoren bzw. des Schichtisolators und des schichtübergreifenden Leiters zueinander wie folgt.

Ein isolierendes Segment in einer Rückseitenkontaktschicht einer Stapelsolarzelle teilt die Rückseitenkontaktschicht in zwei, in der einen Stapelsolarzelle unterscheidbare Abschnitte. Der schichtübergreifende Leiter einer Stapelsolarzelle ist so angeordnet, dass er die obere Kontaktschicht mit einem Abschnitt der zwei Abschnitte der Rückseitenkontaktschicht einer Stapelsolarzelle im Modul verbindet. Der schichtübergreifende Leiter ist dabei zwischen dem Schichtisolator und einem, der jeweiligen Stapelsolarzelle zuzuordnenden Zellseparator angeordnet. Zwischen dem schichtübergreifenden Leiter und diesem Zellseparator ergibt sich ein Bereich, der zu minimieren ist, da er überwiegend unbeteiligt am Beitrag zum Stromfluss in der betreffenden Stapelsolarzelle ist und somit auch zur Effizienz. Dies bedeutet im selben Sinne, dass der Abstand des schichtübergreifenden Leiters zu dem Zellseparator bzw. umgekehrt zu minimieren ist. Die Schichtisolatoren in den leitfähigen Zwischenschichten verhindern einen Kurzschluss des schichtübergreifenden Leiters mit dem Teil der Stapelsolarzelle, der aktiv zum Stromfluss in der Stapelsolarzelle beiträgt. Die Abstände der Schichtisolatoren zu dem schichtübergreifenden Leiter sind demnach ebenfalls zu minimieren um Verluste zu reduzieren. Die Lage der Schichtisolatoren ergibt sich aufgrund ihrer Funktionalität, wobei diese bezüglich des schichtübergreifenden Leiters auf dessen, von dem Zellseparator abgewandter Seite liegen. Mit anderen Worten, verhindern die Schichtisolatoren erfindungsgemäß einen Fluss eines freien Ladungsträgers zwischen den, durch die Schichtisolatoren gebildeten Unterabschnitten der leitfähigen Zwischenschicht und zwingen somit die Ladungsträger erst in eine der Stapelsolarzelle zugehörige Kontaktschicht zu fließen, von wo aus sie über den schichtübergreifenden Leiter gerichtet weitergeleitet werden. Der schichtübergreifende Leiter im Zusammenwirken mit dem Schichtisolator bewirkt so eine insgesamt senkrecht zu den Schichten und insbesondere zu den leitfähigen Zwischenschichten erfolgenden Strom- bzw. Ladungsträgerfluss in einer Stapelsolarzelle.

Diese Anordnung innerhalb einer Stapelsolarzelle in dem Stapelsolarzellenmodul bewirkt, dass der Fluss der erzeugten Ladungsträger in der Stapelsolarzelle kanalisiert ist, in dem dieser ganz überwiegend bevorzugt über die obere Kontaktschicht und den schichtübergreifenden Leiter zu dem zweiten Abschnitt der Rückseitenkontaktschicht fließt. Die Richtung des Flusses hängt von der Auslegung der Stapelsolarzelle ab. Diese Kanalisation des Ladungsträgerflusses bewirkt, dass in den Stapelsolarzellen die Ausgangsspannung in der Rückseitenkontaktschicht bereitgestellt ist. Dabei bildet der potenzielle Unterschied zwischen den Abschnitten der Rückseitenkontaktschicht im Wesentlichen die Ausgangsspannung einer solchen Stapelsolarzelle im Betriebsmodus, d.h. im Falle das Ladungsträger in den Absorberschichten gebildet sind. So können in dem erfindungsgemäßen Stapelsolarzellenmodul die einzelnen Stapelsolarzellen monolithisch elektrisch in Reihe verschaltet hergestellt werden, sodass eine entstehende Gesamtspannung an einer Rückseitenkontaktschicht bereitgestellt bzw. abgreifbar ist, insbesondere an einem jeweiligen randständigen Abschnitt der Rückseitenkontaktschicht im Stapelsolarzellenmodul.

Eine Solarzelle ist ein dreidimensionales Objekt. Sie weist dabei per Definition eine horizontale (gleich laterale) Erstreckungsrichtung auf, die durch eine x-Achse und einer y-Achse aufgespannt ist. Senkrecht dazu (vertikal) erstreckt sich das Solarmodul entlang der z-Achse, die der Stapelrichtung der Schichten entspricht.

Die isolierenden Segmente in den Rückseitenkontaktschichten, die Schichtisolatoren der leitfähigen Zwischenschichten, die Zellseparatoren und die schichtübergreifenden Leiter weisen neben der Erstreckung entlang der Stapelrichtung der Schichten, der z-Achse, desweitern eine Erstreckung in Richtung der x-Achse auf, mit einer im Vergleich hierzu geringen Erstreckung in Richtung der y-Achse.

Die x-Achse wird festgelegt durch die regelmäßige Erstreckung der isolierenden Segmente in den Rückseitenkontaktschichten, welche Stege in den Rückseitenkontaktschichten bilden.

Jede Schicht weist eine Schichtdicke auf, die sich entlang der z-Achse (vertikal) erstreckt,

Der Begriff "Schicht" bezieht sich insbesondere auf einen dreidimensionalen Körper, der im Wesentlichen durch zwei gegenüberliegende Seiten (Flächen) ausgezeichnet und begrenzt ist und sich in einer Ebene (lateral, hier die x, y-Ebene) erstreckt. Eine Schicht wird dabei aus mindestens einem Material gebildet. Es ist offensichtlich, dass durch Herstellungstoleranzen eine Schicht eine Welligkeit und Oberflächenrauheit aufweisen kann und nicht notwendigerweise vollständig planar bzw. eben ist.

Es wird angemerkt, dass zwischen einigen der offenbarten Schichten weitere Schichten angeordnet sein können, die ein anderes Material oder gleiche Materialien umfassen können, die Aufzählung ist nicht abschließend. Beispiele für weitere mögliche Schichtfolgen sind weiter untenstehend ausgeführt.

Die elektrische Leitfähigkeit ist eine Eigenschaft eines Materials bezüglich der Fähigkeit des Materials, einen elektrischen Strom zu leiten, d. h. freie Ladungsträger wie Elektronen oder Löcher aufzuweisen. Je größer (oder höher) die elektrische Leitfähigkeit des Materials ist, desto besser kann das Material den elektrischen Strom leiten. Durch die elektrische Leitfähigkeit bzw. deren Fehlen, ist immer auch der spezifische Widerstand eines Materials bestimmt.

Der Begriff, dass ein Abschnitt oder Unterabschnitt von einem anderen Abschnitt "elektrisch isoliert" ist, bedeutet insbesondere, dass die elektrische Leitfähigkeit der entsprechenden Isolierung oder des isolierenden Segments wesentlich kleiner ist (Widerstand > 10⁸ Ω·cm) als die elektrische Leitfähigkeit der angrenzenden Abschnitte der Schichten und insbesondere auch bezüglich der in der z-Richtung angrenzenden Schichten.

Erfindungsgemäß umfasst die Gruppe zentraler Schichten, wie oben bereits eingeführt, einen schichtübergreifenden Leiter, der sich durch die Schichten der Gruppe zentraler Schichten erstreckt und dabei durch den zweiten Unterabschnitt der leitfähigen Zwischenschicht. Der schichtenübergreifende Leiter kann dabei in Segmente unterteilt sein. Dies erfolgt z.B., in dem die einzelnen Teilsolarzellen jeweils ein leitfähiges Segment umfassen und dass die leitfähigen Zwischenschichten jeweils ein leitfähiges Segment umfassen Die leitfähigen Segmente sind dabei in Richtung der z-Achse übereinander in dem Schichtstapel, gebildet aus den zentralen Schichten, angeordnet. Die Segmente beschränken sich nicht notwendigerweise auf jeweils eine Schicht, sondern können sich z.B. auch über die Schichten einer Teilsolarzelle und eine leitfähige Zwischenschicht erstrecken, das heißt partiell schichtübergreifend vorliegen. Die leitfähigen Segmente bzw. der aus ihnen gebildete schichtübergreifende Leiter erstreckt sich neben der Erstreckung senkrecht zur Stapelrichtung entlang der x-Achse und weisen eine Breite auf, die sich entlang der y-Achse erstreckt.

Der schichtübergreifende Leiter bzw. die leitfähigen Segmente sind derart angeordnet, dass die obere Kontaktschicht mit einem Abschnitt der Rückseitenkontaktschicht elektrisch verbunden ist.

Der hieraus resultierende Stromfluss, der wie oben beschreiben dazu führt, dass die Ausgangsspannung der Stapelsolarzellen in der Rückseitenkontaktschicht bereitgestellt ist, erlaubt die monolithische Verbindung in Reihe mehrerer Stapelsolarzellen im Modul, was zu einer Spanungserhöhung führt, statt zu einer Erhöhung des elektrischen Stroms und was einen Vorteil der Erfindung ausmacht. Zudem wird der Stromfluss in den einzelnen Teilsolarzellen der Stapelsolarzellen nicht geteilt bzw. mit anderen Worten, sind die Teilsolarzellen der Stapelsolarzellen ebenfalls in Reihe geschaltet, was wiederum die Voraussetzung für die erfindungsgemäße Verschaltung in Reihe mehrerer erfindungsgemäßer Stapelsolarzellen in einem Modul ermöglicht und damit die Steigerung der Effizienz da Verluste reduziert sind.

Die elektrische Leitfähigkeit des schichtübergreifenden Leiters bzw. der leitfähigen Segmente ist insbesondere größer als die elektrische Leitfähigkeit der Schichten in der Gruppe zentraler Schichten, bis auf die Leitfähigkeit der leitfähigen Zwischenschicht, welche mindestens gleich groß oder aber größer ist. Der schichtübergreifende Leiter, gegebenenfalls zusammengesetzt aus den leitfähigen Segmenten in den Schichten, bewirkt, dass der Ladungsträgerfluss von der oberen Kontaktschicht zu der Rückseitenkontaktschicht vorwiegend durch den Leiter erfolgt und somit kanalisiert ist.

Die obere Kontaktschicht ist mindestens transluzent und insbesondere transparent für Sonnenlicht.

Die leitfähige Zwischenschicht ist ebenfalls mindestens transluzent und insbesondere transparent für Sonnenlicht.

Folgende Schichten, wie diese aus dem Stand der Technik bekannt sind, können in einzelnen Teilsolarzellen zu deren Vervollständigung angeordnet sein. Pufferschichten zwischen den Absorberschichten und den leitfähigen Zwischenschichten sowie intrinsische Schichten zwischen den Absorberschichten und den leitfähigen Zwischenschichten.

Die Pufferschichten können einen n-Puffer umfassen und bestehen im Falle von Perowskit-Tandemsolarzellen z.B. aus Cadmiumsulfid (CdS), Zinkoxid (ZnO) oder Zinksulfid (ZnS).

Die intrinsischen Schichten können ein intrinsisches Zinkoxid (i-ZnO) umfassen oder bestehen daraus. Andere Materialien mit vergleichbaren Eigenschaften der Leitfähigkeit und Transparenz sind möglich für die Bildung intrinsischer Schichten.

Diese zusätzlichen Schichten werden von dem schichtübergreifenden Leiter und dem Zellseparator ebenfalls erfasst.

Entsprechend einer ersten Ausführungsform sind die Stapelsolarzellen des erfindungsgemäßen Stapelsolarzellenmoduls Tandemsolarzellen.

In einer zweiten Ausführungsform ist die jeweils untere, d.h. der Rückseitenkontaktschicht am nächsten angeordnete Schicht einer Teilsolarzelle der Tandemsolarzellen mit der Rückseitenkontaktschicht lokal einstückig verbunden", d.h. dass die Rückseitenkontaktschicht, welche insbesondere eine Metallschicht ist, direkt mit der ihr zugewandten Oberfläche der unteren Shicht stoffschlüssig verbunden ist. Dies bedeutet in anderen Worten, dass die Verbindung ohne Zwischenlagerung weiterer Zusatzmaterialien, wie z. B. niedrigschmelzender Lötmaterialien erfolgt. Dies trifft in dieser Ausführungsform der Tandemsolarzelle auch für die Verbindung der leitfähigen Zwischenschicht mit der untersten Schicht der oberen Teilsolarzelle und der oberen Kontaktschicht mit der oberen Schicht dieser Teilsolarzelle zu. Diese Form der einstückigen Verbindung wird im Sinne der Erfindung auch als positiver Kontakt bezeichnet. Die Ausführungsform ist entsprechend auch als monolithische Tandemsolarzelle (aus einem Block) anzusprechen.

Gemäß einer dritten Ausführungsform umfasst die Rückseitenkontaktschicht ein Metall, insbesondere ein Übergangsmetall, insbesondere ein Metall aus der Gruppe Molybdän, Wolfram, Chrom, Tantal, Niob, Vanadium, Titan und Mangan. Die Rückseitenkontaktschicht ist in vorteilhafter Weise auf Glassubstraten angeordnet.

Absorberschichten bzw. ein von ihnen umfasstes Absorbermaterial besteht für eine Teilsolarzelle einer Stapelsolarzelle in vorteilhafter Weise aus einem Halbleitermaterial das insbesondere eines aus der Gruppe der Verbindungen von Kupfer, Indium, Gallium, und Selen oder von Kupfer, Indium, Gallium und Schwefel oder Kupferindiumgallium-(di)selenid oder Kupferindiumgallium-(di)sulfid (Cu(In,Ga)(S,Se)₂) oder CdTe ist.

Im Kontext dieser Anmeldung wird Kupferindiumgallium-(di)selenid auch als CIGS bezeichnet.

Die leitfähigen Zwischenschichten können ein erstes transparentes leitfähiges Oxid umfassen, wobei dieses z.B. eines der Materialien aus der Gruppe aluminiumdotiertes Zinkoxid, CuO₂, ZnMgO:AI, Zn(S,O):Al, Zn:B, ZnO:B, Indiumoxid (ITO), zinndotiertes Indiumoxid oder hydriertes Indiumoxid (IOH) umfasst oder daraus bestehtund insbesondere aluminiumdotiertes Zinkoxid ist.

Die obere Absorberschicht der oberen Teilsolarzelle in Tandemsolarzellenausführung ist gemäß einer vierten Ausführungsform aus Perowskit gebildet.

Die oberen Kontaktschichten sind aus einem zweiten transparenten leitfähigen Oxid gebildet oder umfassen ein solches, welches insbesondere Indiumzinkoxid ist.

Die untere Teilsolarzelle in Tandemsolarzellenausführung kann einen n-Puffer umfassen, der auf einer Seite der Absorberschicht die von der Rückseitenkontaktschicht abgewandt ist, anzuordnen ist. Der n-Puffer kann aus Cadmiumsulfid (CdS) ZnO oder ZnS gebildet sein. Die untere Teilsolarzelle kann alternativ auch eine intrinsische Zinkoxid- (i-ZnO) Schicht umfassen, die auf der Seite der Absorberschicht, die von der Rückseitenkontaktschicht abgewandt ist, anzuordnen ist. Die intrinsische Zinkoxidschicht kann auch auf dem n-Puffer, auf der von der Rückseitenkontaktschicht abgewandten Seite, angeordnet sein.

In vorteilhafter Weise umfassen die schichtenübergreifenden Leiter jeweils eine obere und eine untere Grenzschicht, wobei die oberen Grenzschichten an die oberen Kontaktschichten grenzen und die unteren Grenzschichten an die Rückseitenkontaktschichten. Die oberen Grenzschichten umfassen ein erstes leitfähiges Material und die unteren Grenzschichten ein zweites leitfähiges Material. Das erste leitfähige Material ist insbesondere ein transparentes leitfähiges Oxid, z.B. Indiumzinkoxid oder ein verwandtes Material. Das zweite leitfähige Material ist insbesondere ein lasertransformiertes Kupferchalkogenid oder Kupferindiumgallium-(di)sulfid oder ein verwandtes Material. Die oberen und unteren Grenzschichten sind über den schichtübergreifenden Leiter miteinander elektrisch verbunden. Das erste leitfähige Material ist in vorteilhafter Weise gebildet aus dem Material der oberen Kontaktschicht.

Die isolierenden Segmente in den Rückseitenkontaktschichten sind insbesondere aus dem Material der an diese zunächst angeordneten Absorberschicht gebildet. Die Schichtisolatoren sind insbesondere aus dem Material der auf sie abgeschiedenen Absorberschichten gebildet.

Das erfindungsgemäße Stapelsolarzellenmodul ist aus mindestens zwei erfindungsgemäßen Stapelsolarsolarzellen, wie obenstehend beschrieben, gebildet. Erfindungsgemäß ist dabei jeweils eine Stapelsolarzelle über einen Abschnitt ihrer Rückseitenkontaktschicht mit einer benachbarten Stapelsolarsolarzelle elektrisch über diesen einen Abschnitt der Rückseitenkontaktschicht verbunden und die elektrische Verbindung somit einstückig ausgebildet. Dabei ist zu gewährleisten, dass die Ströme der Stapelsolarzellen und der Teilsolarzellen entsprechend der Reihenschaltung aufeinander abgestimmt sind.

Aus dieser Verschaltung der erfindungsgemäßen Tandemsolarzellen zu einem Modul resultiert, dass die Tandemsolarzellen in dem Modul monolithisch in Reihe geschaltet sind, d.h. es liegt nur ein Strompfad in dem Modul vor. Dies ist hier vorteilhaft realisiert, so dass es zu keiner Addition der Ströme der einzelnen Zellen kommt und die Wärmeverluste verringert sind, wodurch wiederum sich die Effizienz erhöht. Weiterhin vorteilhaft ist die Möglichkeit der monolithischen Ausgestaltung der Verbindungen der Zellen untereinander, welches eine vereinfachte Herstellung bedeutet. Die Ausgestaltung des Stromflusses in den erfindungsgemäßen Tandemsolarzellen ist die Voraussetzung für die erfindungsgemäße Verschaltung in Reihe der Tandemsolarzellen im Modul.

Entsprechend der Reihenschaltung ist die Stromstärke in jeder Tandemsolarzelle des Moduls gleich, die Gesamtspannung des Moduls ergibt sich hingegen aus der Summe der Teilspannungen der einzelnen Tandemsolarzellen im Modul.

Ein weiterer Aspekt der Erfindung bezieht sich auf ein Verfahren zum Herstellen eines erfindungsgemäßen Stapelsolarzellenmoduls bzw. eines erfindungsgemäßen Moduls.

Das Verfahren umfasst mindestens die Schritte:
1. Bereitstellen einer Rückseitenkontaktschicht oder Abscheidung einer Rückseitenkontaktschicht auf einem Substrat;
2. Erzeugen von isolierenden Segmenten in der Rückseitenkontaktschicht, die sich entlang einer ersten Richtung in der Rückseitenkontaktschicht erstrecken, welche die x-Achse bildet und welche in regelmäßigen ersten Abständen senkrecht zu der x-Achse angeordnet sind;
3. Abscheiden der Schichten einer Teilsolarzelle, welche mindestens eine Absorberschicht umfasst;
4. Abscheiden einer leitfähigen Zwischenschicht;
5. Erzeugen von Schichtisolatoren in der leitfähigen Zwischenschicht, die sich entlang der x-Achse erstrecken, insbesondere durch ein selektives Laserablationsverfahren oder durch ein Photolithographieverfahren und regelmäßig in Abständen, die den ersten Abständen entsprechen, senkrecht zur x-Achse angeordnet sind;
6. Wiederholen der Schritte 3. bis 5. bis zum Abscheiden der Schichten einer letzten Teilsolarzelle wonach die Schritte 4. und 5. entfallen;
7. Erzeugen von schichtübergreifenden Leitern, die die zuletzt abgeschiedene Schicht umfassen und von dieser bis zur Rückseitenkontaktschicht reichen, insbesondere durch ein Laserablationsverfahren, in einer Erstreckung entlang der x-Achse und regelmäßig in Abständen senkrecht zur x-Achse, die den ersten Abständen entsprechen und wobei der schichtenübergreifende Leiter aus Segmenten gebildet sein kann die pro Schicht nach deren jeweiligen Abscheidung in den Schritten 3., 4. und 5. einbringbar sind oder auch schichtübergreifend nach dem Abscheiden von jeweils mindestens zwei der betreffenden Schichten und wobei die Segmente entlang einer Stapelrichtung der Schichten übereinander angeordnet sind und wobei jeweils die Segmente oder jeweils der gesamte schichtübergreifende Leiter mit einem Material, das mindestens über eine Leitfähigkeit verfügt, die größer oder gleich der größten Leitfähigkeit in den Schichten ist, verfüllt werden;
8. Abscheidung einer oberen Kontaktschicht;
9. Erzeugen von Zellseparatoren die sich von der oberen Kontaktschicht einschließlich bis zu einschließlich der, der Rückseitenkontaktschicht zunächst angeordneten Schicht einer Teilsolarzelle entlang der x-Achse erstrecken, insbesondere durch mechanisches Ritzen und regelmäßig in Abständen senkrecht zur x-Achse, die den ersten Abständen entsprechen, sodass zwischen den Zellseparatoren in jeder derart gebildeten Stapelsolarzelle jeweils ein isolierendes Segment, ein Schichtisolator und ein schichtübergreifender Leiter angeordnet ist und wobei der schichtübergreifende Leiter zwischen den Schichtisolatoren und den Zellseparatoren bzw. im Falle einer in einer Reihe des Moduls endständigen Stapelsolarzelle dem Ende des Stapelsolarzellenmoduls angeordnet ist.

Erfindungsgemäß sind dabei die isolierenden Segmente, die Schichtisolatoren und die Zellseparatoren durch die Schaffung von Gräben bzw. Einschnitten in den Schichten, die durch die Laserablation oder andere Verfahren erzeugt werden, zu verwirklichen. In vorteilhafter Weise sind diese Bereiche jedoch zusätzlich durch die Verfüllung eines elektrisch isolierenden Materials, im Anschluss an die jeweiligen Schritte der Erzeugung, in ihrer Isolierfunktion zu verbessern. Das isolierende Material hat dabei eine elektrische Leitfähigkeit, die geringer ist als die jeweilige Leitfähigkeit in den Schichten und insbesondere so gering, dass das Material als elektrischer Isolator einzustufen ist (Widerstand > 10⁸ Ω·cm). Insbesondere besteht dieses Material aus den Materialien der Absorber.

Die Rückseitenkontaktschicht kann auf einem Substrat abgeschieden werden. Insbesondere kann die Rückseitenkontaktschicht auf das Substrat z.B. gesputtert, aufgedampft oder durch galvanische Abscheidung hergestellt werden.

Eine Absorberschicht kann beispielsweise durch die Verfahren der sogenannten "In-Line RTP" (engl. Rapid Thermal Annealing, dt. prozessintegrierte schnelle thermische Bearbeitung) und Ko-Verdampfung abgeschieden werden.

Die leitfähigen Zwischenschichten sind z.B. durch Sputtern (Kathodenzerstäubung) an Absorberschichten abscheidbar.

Eine Absorberschicht kann beispielsweise eine Perowskit-Schicht sein und durch ein Spin-Coating-Verfahren auf eine leitfähige Zwischenschicht abgeschieden werden.

Die oberen Kontaktschichten sind z.B. durch Sputtern an einer Perowskit-Schicht abscheidbar.

Das erfinderische Verfahren ist durch folgende kombinierbare zusätzliche Schritte in vorteilhafter Weise auszugestalten.
- Abscheiden von Absorbermaterial in die isolierenden Segment in den Rückseitenkontaktschichten im Schritt 3.
- Erzeugen einer unteren Grenzschicht für den Kontakt der schichtübergreifenden Leiter mit den Rückseitenkontaktschichten an der selbigen nach dem Schritt 3. durch-Abscheiden der Absorberschicht und durch Transformation der Absorberschicht mit einem Licht, insbesondere unter Verwendung eines Lasers.
- Abscheiden des Materials von Absorberschichten in den Schichtisolatoren im Schritt 6.
- Abscheiden der oberen Kontaktschicht, Schritt 8., und dabei Verfüllung der schichtübergreifenden Leiter bzw. deren Segmente mit dem leitfähigen Material der oberen Kontaktschicht.

Die Erfindung wird nachfolgend in zwei Figuren und Ausführungsbeispielen näher erläutert.

Die Figuren zeigen:
- Fig.1: Schematische Querschnittsansicht eines Ausschnitts eines erfindungsgemäßen Stapelsolarzellenmodul ;
- Fig. 2: Schematische Querschnittsansicht eines erfindungsgemäßen Stapelsolarzellenmoduls im Ausschnitt mit zwei Tandemsolarzellen.

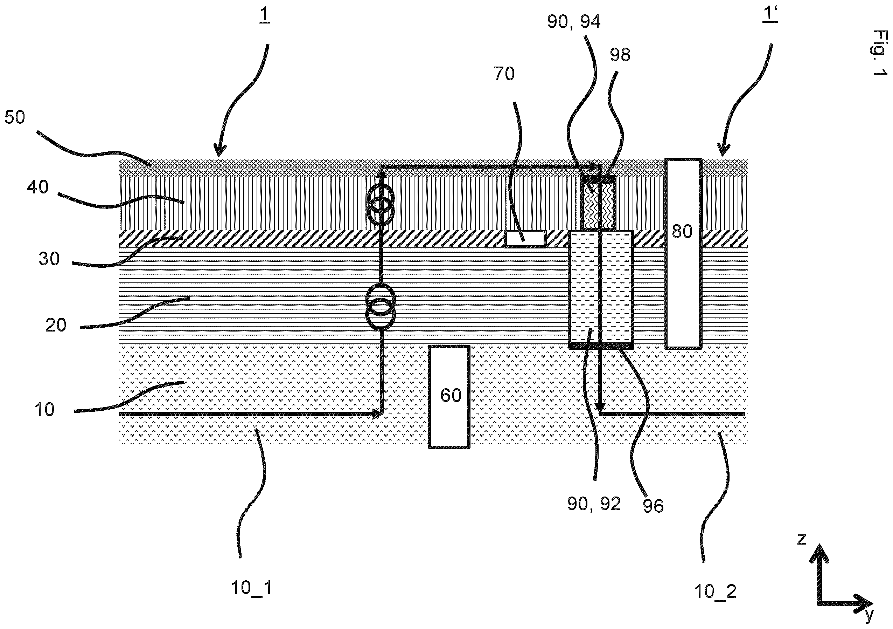

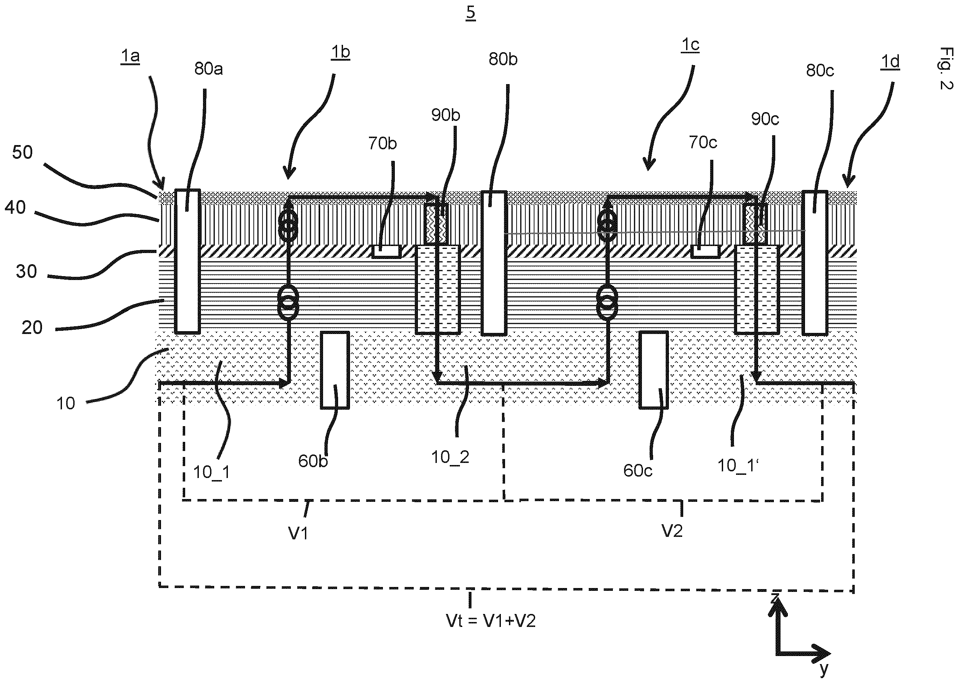

Ein Ausschnitt aus einem erfindungsgemäßen Stapelsolarzellenmodul mit einer ganzen Stapelsolarzelle 1 und einer angrenzenden, nur teilweise gezeigten weiteren Stapelsolarzelle 1', ist in Fig. 1 abgebildet. Das Stapelsolarzellenmodul der Fig.1 und Fig.2 entspricht dem Ausführungsbeispiel für ein Tandemsolarzellenmodul. In der Fig. 1 umfassen die Tandemsolarzellen 1, 1' im Modul mehrere Schichten bzw. Schichtfolgen der Teilsolarzellen (10, 20, 30, 40, 50). Die Schichtebenen sind aufgespannt durch bzw., parallel zur x- und y-Achse (Achsensystem ist unten rechts mit abgebildet). Senkrecht hierzu, in der Stapelrichtung der Schichten liegt die z-Achse. Die x-Achse ist in der Ansicht der Fig. 1 senkrecht zur Zeichenebene orientiert und zeichnet sich dadurch aus, dass sich das isolierende Segment 60_in der Rückseitenkontaktschicht 10 und der Schichtisolator 70 in der leitfähigen Zwischenschicht 30, der Zellseparator 80 sowie der schichtübergreifende Leiter 90 entlang der Richtung der x-Achse durch die gesamte Ausdehnung in Richtung der x-Achse der jeweiligen Schicht erstrecken.

Die Tandemsolarzelle 1 der Fig. 1 weist eine Rückseitenkontaktschicht 10, eine Teilsolarzelle 20, eine leitfähige Zwischenschicht 30, eine zweite Teilsolarzelle 40 und eine obere Kontaktschicht 50 auf.

In der Rückseitenkontaktschicht 10 ist das isolierende Segment 60 und in der leitfähigen Zwischenschicht der Schichtisolator 70 angeordnet. Das isolierende Segment 60 teilt dabei die Rückseitenkontaktschicht 10 in zwei Abschnitte, die zur Unterscheidung als einen ersten 10_1 und zweiten 10_2 anzusprechenden Abschnitt innerhalb einer Stapelsolarzelle bezeichnet sind. Der schichtübergreifende Leiter 90 ist im Ausführungsbeispiel aus zwei Segmenten 92, 94 gebildet, wobei ein unteres Segment (der Rückseitenkontaktschicht zugewandtes) in der Teilsolarzelle 20 und der leitfähigen Zwischenschicht 30, schichtenübergreifend, angeordnet ist und ein oberes Segment 94 in Richtung der z-Achse direkt oberhalb des unteren Segments in der oberen Teilsolarzelle 40 angeordnet ist. Zwischen dem oberen Segment 94 des schichtübergreifenden Leiters 90 und der oberen Kontaktschicht 50 ist eine obere Grenzfläche 98 aus einem leitfähigen Material gebildet und zwischen dem unteren Segment 92 und der Rückseitenkontaktschicht 10 eine untere Grenzschicht 96. Der Zellseparator 80 ist so angeordnet, dass die obere Kontaktschicht 50, die oberer Teilsolarzelle 40, die leitfähige Zwischenschicht 30 und die untere Teilsolarzelle 20 getrennt und elektrisch isoliert von den Schichten der angrenzenden Tandemsolarzelle 1' vorliegen, wodurch zwei Tandemsolarzellen 1, 1' gebildet sind (zweite Zelle 1' nur Ausschnittsweise gezeigt). Durch die Anordnung des schichtübergreifenden Leiters 90 zwischen dem Zellseparator 80 und dem Schichtisolator 70 und der Verbindung des schichtübergreifenden Leiters 90 der oberen Kontaktschicht 50 mit einem der, durch das isolierende Segment 60 gebildeten Abschnitte in der Rückseitenkontaktschicht, ist der erfindungsgemäße Stromfluss in der Stapelsolarzelle, hier im Beispiel eine Tandemsolarzelle, verwirklicht. Durch das Zusammenwirken des isolierenden Segments 60 mit dem Schichtisolator 70, dem Zellseparator 80 und dem schichtübergreifenden Leiter 90 sowie deren Anordnung zueinander, liegt, durch den hierdurch gebildeten Strompfad zwischen dem ersten 10_1 und zweiten Abschnitt 10_2 der Rückseitenkontaktschicht eine Spannung an.

In der Fig. 1 ebenfalls gezeigt ist der Strompfad in der erfindungsgemäßen Stapelsolarzelle, im Beispiel eine Tandemsolarzelle, angedeutet durch die Pfeile, und zusätzlich in der unteren 20 und oberen 40 Teilsolarzelle, die, durch die Lichtabsorption generierten freien Ladungsträger, dargestellt als Kreise, die entlang des Strompfads fließen. Die beiden Teilsolarzellen in der Tandemsolarzelle sind dabei selber auch in Reihe geschaltet.

Fig. 2 zeigt einen größeren Ausschnitt des erfindungsgemäßen Tandemsolarzellenmoduls 5. Der gezeigte Ausschnitt des Tandemsolarzellenmoduls 5 umfasst eine erste 1a, nur teilweise gezeigte, zwei weitere Tandemsolarzelle 1b, 1c sowie am äußeren rechten Rand eine ebenfalls nur teilweise gezeigte weitere Tandemsolarzelle 1d. Die Zellseparatoren 80a, 80b und 80c sind jeweils den Tandemsolarzellen 1a, 1b bzw. 1c zuzuordnen. Die hier gezeigten erfindungsgemäßen Tandemsolarzellen 1a, 1b, 1c, 1d sind entsprechend dem ersten Ausführungsbeispiel der Fig. 1 ausgeführt. In der Fig. 2 ist das Prinzip der Verschaltung in Reihe der Stapelsolarzellen in dem Stapelsolarzellenmodul und insbesondere die monolithische Ausführung der elektrischen Verschaltung der Stapelsolarzellen ersichtlich. Dabei teilt jede Stapelsolarzelle 1a, 1b, 1c, 1d einen jeweiligen zur Unterscheidung als ersten 10_1, 10_1'und zweiten 10_2 anzusprechenden Abschnitt der zwei Abschnitte der Rückseitenkontaktschicht 10 mit der jeweils angrenzenden Stapelsolarzelle.

Wie aus der Fig. 2 gleichfalls zu sehen ist, addieren sich die, in den in dem Modul in Reihe geschalteten Stapelsolarzellen 1a, 1b, zwischen deren Abschnitten 10_1 und 10_1' in der Rückseitenkontaktschicht 10 anliegenden Spannungen V1, V2 zu einer Gesamtspannung Vt, während der erzeugte elektrische Strom im Wesentlichen von der Anzahl der Stapelsolarzellen unabhängig ist, wodurch sich der Vorteil der Erfindung ergibt.

Das Ausführungsbeispiel für das Verfahren umfasst folgende Schritte:
1. Bereitstellen einer Molybdänschicht auf einem Glassubstrat als Rückseitenkontaktschicht 10 durch aufsputtern des Molybdäns auf das Glassubstrat.
2. Erzeugen der isolierenden Segmente 60 in der Rückseitenkontaktschicht 10, entlang einer ersten Erstreckung, welche die x-Achse bildet, und in regelmäßigen ersten Abständen senkrecht zu der x-Achse durch Laserablation (im Laborjargon als P1 bezeichnet).
3. Abscheiden einer CIGS-Schicht als Absorberschicht 20 auf der Rückseitenkontaktschicht 10, gefolgt von dem Abscheiden einer CdS-Pufferschicht als zusätzliche Schicht und einer i-ZnOintrinsischen Schicht als weitere zusätzliche Schicht.
4. Abscheiden einer ZnO:Al-Schicht als leitfähige Zwischenschicht 30.
4.a Erzeugen von schichtübergreifenden Segmenten 92 des schichtübergreifenden Leiters 90 gemäß Schritt 7. des erfindungsgemäßen Verfahrens, durch Lasertransformation der Materialien entlang der x-Achse und in regelmäßigen Abständen entsprechend des ersten Abstands senkrecht zur x-Achse in den im Schritt 3. und 4. vorherig abgeschiedenen Schichten (im Laborjargon als P2(ns) bezeichnet).
5. Erzeugen von Schichtisolatoren 70 in der leitfähigen Zwischenschicht 30 entlang der x-Achse und in regelmäßigen Abständen entsprechend des ersten Abstands senkrecht zur x-Achse durch selektive Laserablation (im Laborjargon als P3 bezeichnet).
6. Abscheiden einer Perowskit-Schicht und weiteren funktionalen Schichten zur Bildung einer Perowskit-Teilsolarzelle 40.
7. Anlegen eines Segments 94 des schichtübergreifenden Leiters 90, durch mechanisches Ritzen entlang der x-Achse und in regelmäßigen Abständen senkrecht zur x-Achse genau oberhalb und entlang der in Schritt 4a erzeugten schichtübergreifenden Segmente 92 des schichtübergreifenden Leiters 90 in den, in den Schritten 5. und 6. abgeschiedenen Schichten (im Laborjargon als P2(ns) bezeichnet).
8. Abscheiden einer Indium-Zinnoxid-Schicht als obere Kontaktschicht 50 unter gleichzeitiger Verfüllung der in Schritt 7. angelegten Segmente 94 des schichtübergreifenden Leiters 90.
9. Erzeugen von Zellseparatoren 80 die sich von der oberen Kontaktschicht 50 einschließlich bis zur unteren, d.h. der Rückseitenkontaktschicht 10 am nächsten angeordneten Schicht, hier die CIGS-Schicht als Absorberschicht einschließlich entlang der x-Achse erstrecken, insbesondere durch mechanisches Ritzen (im Laborjargon als P4 bezeichnet) und in regelmäßigen Abständen entsprechend des ersten Abstands senkrecht zur x-Achse, sodass zwischen den Zellseparatoren jeweils ein isolierendes Segment, ein Schichtisolator und ein schichtübergreifender Leiter angeordnet ist und wobei der schichtübergreifende Leiter 90 zwischen einem, der betreffenden Solarzelle zuzuordnenden Zellseparator 80 und dem Schichtisolator 70 angeordnet ist.

Demnach ergeben sich als konkretes Ausführungsbeispiel für die Stapelsolarzellen im Stapelsolarzellenmodul, CIGSe-Perowskit-Tandemsolarzellen.

## Patentansprüche

1. Stapelsolarzellenmodul (5) mindestens aufweisend zwei Stapelsolarzellen (1, 1', 1a-1d).
• wobei jede der Stapelsolarzellen (1, 1', 1a-1d)
- eine Rückseitenkontaktschicht (10), eine Gruppe zentraler Schichten (20, 30, 40) und eine obere Kontaktschicht (50) aufweist und wobei die Gruppe zentraler Schichten (20, 30, 40) dabei mindestens zwei Teilsolarzellen (20, 40) mit mindestens jeweils einer Absorberschicht umfasst und jeweils zwischen zwei Teilsolarzellen (20, 40) mindestens eine leitfähige Zwischenschicht (30) angeordnet ist und
- in der Rückseitenkontaktschicht (10) ein isolierendes Segment (60) aufweist, das die Rückseitenkontaktschicht (10) elektrisch trennt, so dass Abschnitte (10_1, 10_1', 10_2) gebildet sind und
- in der leitfähigen Zwischenschicht (30) einen Schichtisolator (70) aufweist und
- einen schichtübergreifender Leiter (90), der die Gruppe zentraler Schichten (20, 30, 40) umfasst und die obere Kontaktschicht (50) elektrisch mit einem Abschnitt (10_1, 10_1', 10_2) der Rückseitenkontaktschicht (10) verbindet aufweist und wobei
• die einzelnen Stapelsolarzellen (1, 1', 1a-1d) ,in dem Stapelsolarzellenmodul (5) durch Zellseparatoren (80) voneinander getrennt sind, die sich von der oberen Kontaktschicht (50) und diese umfassend bis zu der, der Rückseitenkontaktschicht (10) am nächsten liegenden Schicht einer Teilsolarzelle (20) und diese umfassend, erstrecken und wobei für eine, in einer Reihe endständige Stapelsolarzelle (1, 1', 1a-1d) im Stapelsolarzellenmodul (5) der Zellseparator (80) durch das Enden des Moduls (5) gegeben ist und wobei
• in jeder Stapelsolarzelle (1, 1', 1a-1d) der schichtübergreifende Leiter (90) zwischen dem Schichtisolator (70) und einem Zellseparator (80) angeordnet ist und
• jeweils zwei benachbarte Stapelsolarzellen (1, 1', 1a-1d) über einen, sich von einer Stapelsolarzelle (1, 1', 1a-1d) in die nächste erstreckenden Abschnitt der Rückseitenkontaktschicht (10_1, 10_1', 10_2) elektrisch verbunden sind.

2. Stapelsolarzellenmodul (5) nach Anspruch 1,
**dadurch gekennzeichnet, dass**
die Stapelsolarzellen (1, 1', 1a-1d) als Tandemsolarzellen ausgebildet sind.

3. Stapelsolarzellenmodul (5) nach Anspruch 2,
**dadurch gekennzeichnet, dass**
die Tandemsolarzellen (1, 1', 1a-1d) monolithisch ausgebildet sind.

4. Stapelsolarzellenmodul (5) nach Anspruch 1 oder 2,
**dadurch gekennzeichnet, dass**
die Rückseitenkontaktschicht (10) ein Metall, insbesondere ein Übergangsmetall, insbesondere ein Metall aus der Gruppe Molybdän, Wolfram, Chrom, Tantal, Niob, Vanadium, Titan und Mangan umfasst.

5. Stapelsolarzellenmodul (5) nach Anspruch 2
**dadurch gekennzeichnet, dass**
die Tandemsolarzellen (1, 1', 1a-1d) als Perowskit-Tandemsolarzellen ausgebildet sind.

6. Verfahren zum Herstellen eines Stapelsolarzellenmoduls (5) umfassend mindestens die folgenden Schritte,
1. Bereitstellen einer Rückseitenkontaktschicht (10) oder Abscheidung einer Rückseitenkontaktschicht (10) auf einem Substrat;
2. Erzeugen von isolierenden Segmenten (60) in der Rückseitenkontaktschicht (10), die sich entlang einer ersten Richtung in der Rückseitenkontaktschicht erstrecken, welche die x-Achse bildet und wobei die isolierenden Segmente (60) in regelmäßigen ersten Abständen senkrecht zu der x-Achse angeordnet sind
3. Abscheiden einer Absorberschicht (20, 40);
4. Abscheiden einer leitfähigen Zwischenschicht (30);
5. Erzeugen von Schichtisolatoren (70) in der leitfähigen Zwischenschicht (30), die sich entlang der x-Achse erstrecken, insbesondere durch ein selektives Laserablationsverfahren oder durch ein Photolithographieverfahren und regelmäßig in Abständen, die den ersten Abständen entsprechen, senkrecht zur x-Achse angeordnet sind;
6. Wiederholen der Schritte 3. bis 5. bis zum Abscheiden einer letzten Absorberschicht (20, 40) wonach die Schritte 4. und 5. entfallen;
7. Erzeugen von schichtübergreifenden Leitern, die die zuletzt abgeschiedene Absorberschicht (20, 40) umfassen und von dieser bis zur Rückseitenkontaktschicht (10) reichen, insbesondere durch ein Laserablationsverfahren, in einer Erstreckung entlang der x-Achse und regelmäßig in Abständen senkrecht zur x-Achse, die den ersten Abständen entsprechen und wobei der schichtenübergreifende Leiter (90) aus Segmenten (92, 94) gebildet sein kann, welche pro Schicht (20, 30, 40) nach deren jeweiligen Abscheidung in den Schritten 3., 4. und 5. einbringbar sind oder auch schichtübergreifend nach dem Abscheiden von jeweils mindestens zwei der betreffenden Schichten (20, 30, 40) und wobei die Segmente (92, 94) entlang einer Stapelrichtung der Schichten(20, 30, 40) übereinander angeordnet sind und wobei jeweils die Segmente (92, 94) oder jeweils der gesamte schichtübergreifende Leiter (90) mit einem Material, das mindestens über eine Leitfähigkeit verfügt, die größer oder gleich der größten Leitfähigkeit in den Schichten (20, 30, 40) ist, verfüllt werden;
8. Abscheidung einer oberen Kontaktschicht (50) und
9. Erzeugen von Zellseparatoren (80) die sich von der oberen Kontaktschicht (50) einschließlich bis zu der, der Rückseitenkontaktschicht (10) zunächst angeordneten Absorberschicht (20, 40) einschließlich entlang der x-Achse erstrecken, insbesondere durch mechanisches Ritzen und regelmäßig in Abständen senkrecht zur x-Achse, die den ersten Abständen entsprechen, sodass zwischen den Zellseparatoren (80) in jeder derart gebildeten Stapelsolarzelle (1, 1', 1a-1d) jeweils ein isolierendes Segment (60), ein Schichtisolator (70) und ein schichtübergreifender Leiter (90) angeordnet ist und wobei der schichtübergreifende Leiter (90) zwischen den Schichtisolatoren (70) und den Zellseparatoren (80) bzw. im Falle einer in einer Reihe des Moduls endständigen Stapelsolarzelle dem Ende des Stapelsolarzellenmoduls angeordnet ist.
